# EUROPEAN PATENT APPLICATION

(11) **EP 4 092 155 A1**
(43) Date of publication of application: **23.11.2022**
(21) Application number: 20914312.2
(22) Date of filing: 15.06.2020
(51) Int. Cl.: C23C 16/46, C23C 16/458, C23C 16/50, C23C 16/52, C23C 16/513

(54) **HEATING DEVICE AND FILM-COATING APPARATUS**

(30) Priority: 14.01.2020 CN 202020074649 U
(71) Applicant: Longi Solar Technology (Ningxia) Co., Ltd., Yinchuan, Ningxia 750021 (CN)
(72) Inventor: ZHAO, Zanliang, Yinchuan, Ningxia 750021 (CN); ZHAO, Yongtao, Yinchuan, Ningxia 750021 (CN)
(74) Representative: von Bülow & Tamada
(86) International application number: PCT/CN2020/096139
(87) International publication number: WO 2021/143041

(57) **Abstract**

The embodiments of the present application disclose a heating device and a film coating apparatus, wherein the heating device includes: a heating chamber, a cantilever tube, a graphite boat, a first heating member and a second heating member; the cantilever tube is disposed inside the heating chamber, and is spaced from an inner surface of the heating chamber by a preset distance; the graphite boat is disposed on the cantilever tube; the first heating member is disposed inside the cantilever tube; the second heating member is disposed on a surface of the heating chamber; and the heating device heats a bottom of the graphite boat by using the first heating member, and heats the heating chamber by using the second heating member. In the embodiments of the present application, because the cantilever tube and the inner surface of the heating chamber have a spacing therebetween, broken silicon wafers do not cover the outer surface of the cantilever tube, which prevents nonuniform heating to the bottom of the graphite boat. Additionally, because the first heating member in the cantilever tube is utilized to directly heat the graphite boat, as compared with the mode using an auxiliary heating tube in the prior art, the heating efficiency of the heating device can be increased.

## Description

The present application claims the priority of the Chinese patent application filed on January 14th, 2020 before the Chinese Patent Office with the application number of 202020074649.9 and the title of "HEATING DEVICE AND FILM-COATING APPARATUS", which is incorporated herein in its entirety by reference.

### TECHNICAL FIELD

The present application relates to the technical field of solar cells, more particularly to a heating device and a film coating apparatus.

### BACKGROUND

Currently, tube-type PECVD (Plasma-Enhanced Chemical Vapor Deposition) equipment may be used to perform film coating to a silicon wafer. In tube-type PECVD equipment, a graphite boat carrying a silicon wafer is disposed inside a heating process furnace chamber, thereby completing the film coating of the silicon wafer.

However, because the graphite boat has a high width, the middle part of the graphite boat is far from the chamber wall, and the heating speed is low. In order to enable the graphite boat to be uniformly heated, the conventional mode is to provide an auxiliary heating tube at the bottom of the process furnace chamber to heat the middle part of the bottom of the graphite boat.

However, the conventional heating mode has the following problems. Firstly, broken silicon wafers easily cover the auxiliary heating tube at the bottom, whereby the heating to the bottom of the graphite boat by the auxiliary heating tube is nonuniform. Secondly, the auxiliary heating tube and the bottom of the graphite boat are separated by a cantilever tube therebetween, which reduces the absorption of the heat by the graphite boat.

### SUMMARY

In order to solve the above technical problems, the present application discloses a heating device and a film coating apparatus.

In the first aspect, the present application discloses a heating device, wherein the heating device includes: a heating chamber, a cantilever tube, a graphite boat, a first heating member and a second heating member;
the cantilever tube is disposed inside the heating chamber, and is spaced from an inner surface of the heating chamber by a preset distance;
the graphite boat is disposed on the cantilever tube;
the first heating member is disposed inside the cantilever tube;
the second heating member is disposed on a surface of the heating chamber; and
the heating device heats a bottom of the graphite boat by using the first heating member, and heats the heating chamber by using the second heating member.

Optionally, a tube body of the cantilever tube is provided with a notch at a position adjacent to the graphite boat, and the notch extends in an axial direction of the cantilever tube.

Optionally, the cantilever tube includes a structure of a hollow cylinder.

Optionally, a quantity of the cantilever tube is more than one.

Optionally, each of the first heating member and the second heating member includes a heating resistance wire.

Optionally, the graphite boat is provided with an accommodating slot that contains a silicon wafer.

In the second aspect, the present application further discloses a film coating apparatus, wherein the film coating apparatus includes the heating device stated above.

Optionally, the film coating apparatus further includes a radio-frequency power supply, and the radio-frequency power supply is connected to the graphite boat of the heating device.

As compared with the prior art, the embodiments of the present application have the following advantages:
In the embodiments of the present application, inside the heating chamber, the cantilever tube is separated from the inner surface of the heating chamber. Because the cantilever tube and the inner surface of the heating chamber have a spacing therebetween, broken silicon wafers do not cover the outer surface of the cantilever tube, which prevents nonuniform heating to the bottom of the graphite boat by the first heating member in the cantilever tube. Additionally, because the first heating member in the cantilever tube is utilized to directly heat the graphite boat, as compared with the mode using an auxiliary heating tube in the prior art, the cantilever tube and the first heating member do not have a separating component or spacing therebetween, which can increase the heating efficiency of the heating device. Finally, the first heating member in the cantilever tube is utilized to directly heat the graphite boat, and the heat directly acts on the bottom of the graphite boat, which increases the uniformity of the heating to the bottom of the graphite boat, which facilitates the uniformity of the film coating and can reduce rework caused by nonuniform film coating, and reduces the duration of the heating to the bottom of the graphite boat, which can increase the equipment production capacity.

The above description is merely a summary of the technical solutions of the present disclosure. In order to more clearly know the elements of the present disclosure to enable the implementation according to the contents of the description, and in order to make the above and other purposes, features and advantages of the present disclosure more apparent and understandable, the particular embodiments of the present disclosure are provided below.

### BRIEF DESCRIPTION OF THE DRAWINGS

In order to more clearly illustrate the technical solutions of the embodiments of the present disclosure or the prior art, the figures that are required to describe the embodiments or the prior art will be briefly introduced below. Apparently, the figures that are described below are embodiments of the present disclosure, and a person skilled in the art can obtain other figures according to these figures without paying creative work.
FIG. 1 schematically shows a schematic structural diagram of a heating device according to an embodiment of the present application;
FIG. 2 schematically shows a schematic side structural diagram of a heating device according to an embodiment of the present application; and
FIG. 3 schematically shows a schematic side structural diagram of another heating device according to an embodiment of the present application.

### DETAILED DESCRIPTION

In order to make the above purposes, features and advantages of the embodiments of the present disclosure more apparent and understandable, the embodiments of the present disclosure will be described in further detail below with reference to the drawings and the particular embodiments. Apparently, the described embodiments are merely certain embodiments of the present disclosure, rather than all of the embodiments. All of the other embodiments that a person skilled in the art obtains on the basis of the embodiments of the present disclosure without paying creative work fall within the protection scope of the present disclosure.

An embodiment of the present application provides a heating device, wherein the heating device includes: a heating chamber, a cantilever tube, a graphite boat, a first heating member and a second heating member. The cantilever tube is disposed inside the heating chamber, and is spaced from an inner surface of the heating chamber by a preset distance. The graphite boat is disposed on the cantilever tube. The first heating member is disposed inside the cantilever tube. The second heating member is disposed on a surface of the heating chamber. The heating device heats a bottom of the graphite boat by using the first heating member, and heats the heating chamber by using the second heating member.

In the present application, the heating device may be applied to a tube-type PECVD film coating apparatus.

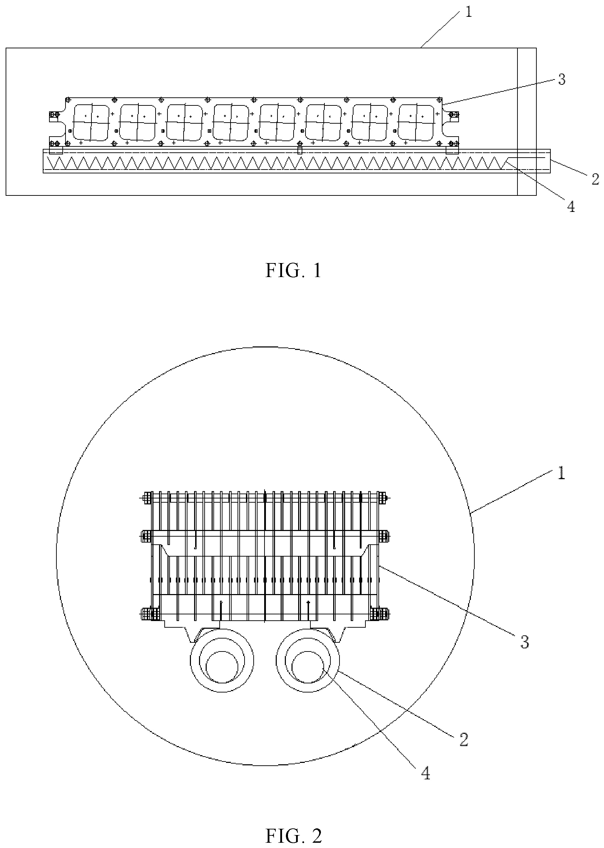

In an embodiment of the present application, referring to FIGs. 1 and 2, the cantilever tube 2 is disposed inside the heating chamber 1, and the graphite boat 3 is disposed on the outer surface of the cantilever tube 2. Because the graphite boat 3 is directly disposed on the outer surface of the cantilever tube 2, and there is no separating component or spacing between them, by heating the graphite boat by using the first heating member 4 disposed inside the cantilever tube 2, the heating efficiency of the heating device can be increased. Additionally, because the cantilever tube 2 and the inner surface of the heating chamber 1 have a spacing therebetween, broken silicon wafers falling from the graphite boat 3 do not cover the outer surface of the cantilever tube 2, which prevents nonuniform heating to the bottom of the graphite boat 3.

Optionally, the preset distance between the cantilever tube and the inner wall of the heating chamber may be set according to the particular structure of the interior of the heating chamber. The embodiments of the present application have such configuration is to prevent broken silicon wafers falling from the graphite boat to cover the outer surface of the cantilever tube, as a result, the preset distance is not particularly limited.

As a particular example, the cantilever tube has a hollow part. The first heating member is disposed at the hollow part, and the cantilever tube carries the graphite boat into the heating chamber. At this point, a chamber door of the heating chamber is closed, the first heating member in the cantilever tube starts to heat, the bottom of the graphite boat is heated, and when a specified temperature is reached, the heating is stopped. A vacuum pump sucks the air inside the heating chamber, and subsequently feeds silane and ammonia gas into the chamber, to stabilize the gas pressure. The radio-frequency power supply starts to discharge, to ionize the silane and the ammonia gas, and the silicon nitride generated by the reaction is coated to the surface of the silicon wafer.

In an embodiment of the present application, the second heating member disposed on the outer wall of the heating chamber is used to heat the heating chamber, thereby heating the graphite boat to the process temperature, while the silicon wafer carried by the graphite boat also reaches the process temperature. The air of the heating chamber is removed by suction, subsequently silane and ammonia gas are fed into the heating chamber, to stabilize the gas pressure, and subsequently the radio-frequency power supply starts to discharge.

Currently, in the prior art, the heating to the bottom of the graphite boat employs the mode of adding an auxiliary heating tube at the bottom of the graphite boat and the lower wall of the chamber. In the embodiments of the present application, the cantilever tube is used for the heating, and the heat directly acts on the bottom of the graphite boat, which increases the uniformity of the heating to the bottom of the graphite boat, which facilitates the uniformity of the film coating and can reduce rework caused by nonuniform film coating, and reduces the duration of the heating to the bottom of the graphite boat, which can increase the equipment production capacity.

Optionally, a tube body of the cantilever tube is provided with a notch at a position adjacent to the graphite boat, and the notch extends in an axial direction of the cantilever tube.

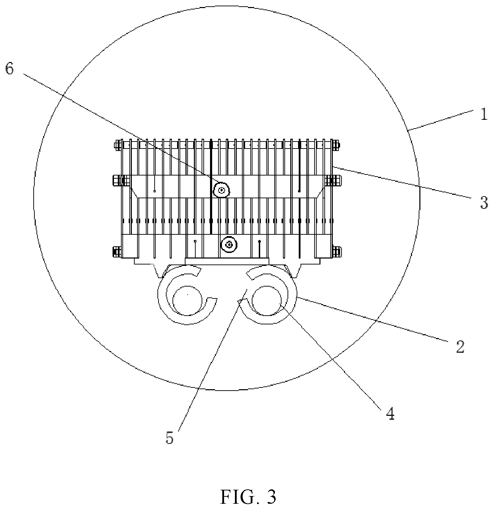

In an embodiment of the present application, referring to FIG. 3, the tube body of the cantilever tube 2 is provided with a notch 5, and the notch 5 extends in the axial direction of the cantilever tube. Optionally, the notch 5 is adjacent to the graphite boat 3. Because the tube body of the cantilever tube 2 is provided with the axially extending notch 5, the first heating member, in the heating, can transfer more heat to the graphite boat 3, which further increases the heating efficiency of the heating device. It can be understood that the particular position of the notch 5 in the tube wall of the cantilever tube is not particularly limited in the embodiments of the present application, as long as it can ensure that the first heating member can be disposed inside the cantilever tube, and can increase the heating efficiency of the heating device.

Optionally, the cantilever tube includes a structure of a hollow cylinder.

In an embodiment of the present application, because the first heating member is disposed inside the cantilever tube, the cantilever tube is configured to be of a hollow structure. Additionally, configuring the cantilever tube to be of a cylindrical structure can prevent silicon wafers scattering on the graphite boat from covering the outer surface of the cantilever tube, which affects the uniformity of the heating to the graphite boat by the first heating member. It can be understood that the cantilever tube may also be of another hollow structure, for example, a hollow regular-hexahedral structure and a hollow regular-trihedral structure, which is not particularly limited in the embodiments of the present application.

Optionally, a quantity of the cantilever tube is more than one.

In an embodiment of the present application, in order to further increase the efficiency of the heating to the graphite boat by the first heating member in the cantilever tube, according to the structure of the heating chamber, the quantity of the cantilever tube may be configured to be a plurality, and each of the cantilever tubes may be provided with a first heating member therein. By using the first heating members inside the plurality of cantilever tubes to heat the graphite boat, the efficiency of the heating to the graphite boat by the heating device can be increased. Optionally, the plurality of cantilever tubes are evenly arranged at the bottom of the graphite boat, which can enable the bottom of the graphite boat to be uniformity heated. Optionally, referring to FIG. 2 or 3, the quantity of the cantilever tubes is 2.

Optionally, each of the first heating member and the second heating member includes a heating resistance wire.

In an embodiment of the present application, heating by using a heating resistance wire is the most simple electricity-based heating method, wherein the heating efficiency can reach nearly 100%, and the operating temperature can reach 2000°C. Therefore, it may be applied to high-temperature heating. The heating using the heating resistance wire according to the present application can satisfy the requirement on the heating temperature by the graphite boat, and can also satisfy the requirement on the heating temperature of the heating chamber, and it has good practical applicability and use value. Certainly, the first heating member or the second heating member may also be other heating members, for example a heating tube, which is not particularly limited in the embodiments of the present application.

Optionally, the graphite boat is provided with an accommodating slot that contains a silicon wafer.

In an embodiment of the present application, an accommodating slot that contains a silicon wafer is disposed on the graphite boat to place the silicon wafer, thereby completing the film coating process of the silicon wafer. Certainly, according to other demands, other articles or devices that are required to be coated a film may be contained in the graphite boat, which is not limited in the embodiments of the present application.

In the embodiments of the present application, inside the heating chamber, the cantilever tube is separated from the inner surface of the heating chamber. Because the cantilever tube and the inner surface of the heating chamber have a spacing therebetween, broken silicon wafers do not cover the outer surface of the cantilever tube, which prevents nonuniform heating to the bottom of the graphite boat by the first heating member in the cantilever tube. Additionally, because the first heating member in the cantilever tube is utilized to directly heat the graphite boat, as compared with the mode using an auxiliary heating tube in the prior art, the cantilever tube and the first heating member do not have a separating component or spacing therebetween, which can increase the heating efficiency of the heating device. Finally, the first heating member in the cantilever tube is utilized to directly heat the graphite boat, and the heat directly acts on the bottom of the graphite boat, which increases the uniformity of the heating to the bottom of the graphite boat, which facilitates the uniformity of the film coating and can reduce rework caused by nonuniform film coating, and reduces the duration of the heating to the bottom of the graphite boat, which can increase the equipment production capacity.

An embodiment of the present application further discloses a film coating apparatus, wherein the film coating apparatus includes the heating device stated above.

Optionally, the heating device further includes a radio-frequency power supply, and the radio-frequency power supply is connected to the graphite boat of the heating device.

In an embodiment of the present application, referring to FIG. 3, the heating device further includes a radio-frequency power supply 6, and the radio-frequency power supply 6 is electrically connected to the graphite boat 3. When the silicon wafer has been mounted on the graphite boat, the radio-frequency power supply, after discharging, can ionize the silane and the ammonia gas fed into the heating chamber. Accordingly, the silicon nitride generated by the reaction is coated to the surface of the silicon wafer, thereby completing the film coating process of the silicon wafer.

The film coating apparatus according to the present application may be a tube-type PECVD (Plasma-Enhanced Chemical Vapor Deposition) film coating apparatus. The film coating apparatus includes the heating device, the heating device is inside the heating chamber, and the cantilever tube is separated from the inner surface of the heating chamber. Because the cantilever tube and the inner surface of the heating chamber have a spacing therebetween, broken silicon wafers do not cover the outer surface of the cantilever tube, which prevents nonuniform heating to the bottom of the graphite boat by the first heating member in the cantilever tube. Additionally, because the first heating member in the cantilever tube is utilized to directly heat the graphite boat, as compared with the mode using an auxiliary heating tube in the prior art, the cantilever tube and the first heating member do not have a separating component or spacing therebetween, which can increase the heating efficiency of the heating device. Finally, the first heating member in the cantilever tube is utilized to directly heat the graphite boat, and the heat directly acts on the bottom of the graphite boat, which increases the uniformity of the heating to the bottom of the graphite boat, which facilitates the uniformity of the film coating and can reduce rework caused by nonuniform film coating, and reduces the duration of the heating to the bottom of the graphite boat, which can increase the equipment production capacity.

The embodiments of the description are described in the mode of progression, each of the embodiments emphatically describes the differences from the other embodiments, and the same or similar parts of the embodiments may refer to each other.

The heating device and the film coating apparatus according to the embodiments of the present application have been described in detail above. The principle and the embodiments of the embodiments of the present application are described herein with reference to the particular examples, and the description of the above embodiments is merely intended to facilitate to understand the method according to the embodiments of the present application and its core concept. Moreover, for a person skilled in the art, according to the concept of the embodiments of the present application, the particular embodiments and the range of application may be varied. In conclusion, the contents of the description should not be understood as limiting the embodiments of the present application.

## Claims

1. A heating device, **characterized in that** the heating device comprises: a heating chamber, a cantilever tube, a graphite boat, a first heating member and a second heating member;
the cantilever tube is disposed inside the heating chamber, and is spaced from an inner surface of the heating chamber by a preset distance;
the graphite boat is disposed on the cantilever tube;
the first heating member is disposed inside the cantilever tube;
the second heating member is disposed on a surface of the heating chamber; and
the heating device heats a bottom of the graphite boat by using the first heating member, and heats the heating chamber by using the second heating member.

2. The heating device according to claim 1, **characterized in that** a tube body of the cantilever tube is provided with a notch at a position adjacent to the graphite boat, and the notch extends in an axial direction of the cantilever tube.

3. The heating device according to claim 1, **characterized in that** the cantilever tube comprises a structure of a hollow cylinder.

4. The heating device according to claim 1, **characterized in that** a quantity of the cantilever tube is more than one.

5. The heating device according to claim 1, **characterized in that** each of the first heating member and the second heating member comprises a heating resistance wire.

6. The heating device according to claim 1, **characterized in that** the graphite boat is provided with an accommodating slot that contains a silicon wafer.

7. A film coating apparatus, **characterized in that** the film coating apparatus comprises the heating device according to any one of claims 1-6.

8. The film coating apparatus according to claim 7, **characterized in that** the film coating apparatus further comprises a radio-frequency power supply, and the radio-frequency power supply is connected to the graphite boat of the heating device.
